# EUROPEAN PATENT APPLICATION

(11) **EP 4 572 564 A1**
(43) Date of publication of application: **18.06.2025**
(21) Application number: 24201178.1
(22) Date of filing: 18.09.2024
(51) Int. Cl.: H10D 62/10, H10D 30/01, H10D 30/43, H10D 30/00, H10D 84/01, H10D 84/03, H10D 84/85

(54) **SEMICONDUCTOR DEVICE**

(30) Priority: 11.12.2023 KR 20230178830; 05.02.2024 KR 20240017767
(71) Applicant: Samsung Electronics Co., Ltd, Suwon-si, Gyeonggi-do 16677 (KR)
(72) Inventor: YU, Hyunkwan, 16677 Suwon-si (KR); JUNG, Yeondo, 16677 Suwon-si (KR); SHIN, Dongsuk, 16677 Suwon-si (KR)
(74) Representative: Marks & Clerk LLP

(57) **Abstract**

A semiconductor device may include a substrate including active regions; gate structures including first and second gate structures intersecting first and second active regions, channel layers on the active regions, surrounded by the gate structures; source/drain regions, connected to channel layers, including a first source/drain region in which the first active region is recessed, having a first conductivity-type, and a second source/drain region in which the second active region is recessed, having a second conductivity-type; internal spacers between the first gate structure and the first source/drain region and between the second gate structure and the second source/drain region, each of the first internal spacers including a spacer insulating film between a spacer dielectric layer and the gate structure, and a thickness of the first internal spacers may be greater than a thickness of the second internal spacers.

## Description

### BACKGROUND

The present disclosure relates to semiconductor devices.

As demand for high performance, high speed, and/or multifunctionality for a semiconductor device increases, a degree of integration of a semiconductor device is increasing. In manufacturing a semiconductor device having a fine pattern in response to the tendency of high integration of semiconductor devices, it is desirable to implement patterns having a fine width or a fine separation distance. Furthermore, in order to overcome the limitation of operating characteristics due to the reduction of a size of the planar metal oxide semiconductor FET (MOSFET), efforts are being made to develop a semiconductor device including a FinFET with a three-dimensional channel.

### SUMMARY

Some aspects of the present disclosure are to provide semiconductor devices having improved integration and reliability.

According to some aspects of the present disclosure, a semiconductor device may include a substrate including a plurality of active regions extending in a first direction and including first and second active regions spaced apart from each other in a second direction, intersecting the first direction; a plurality of gate structures extending on the substrate in the second direction, and including a first gate structure intersecting the first active region and a second gate structure intersecting the second active region; on each of the plurality of active regions, a plurality of channel layers spaced apart from each other in a third direction, perpendicular to an upper surface of the substrate, and surrounded by the gate structure; on one side of each of the plurality of gate structures, a plurality of source/drain regions including a first source/drain region in a first region in which the first active region is recessed, the first source/drain region connected to the plurality of channel layers on the first active region and having a first conductivity-type, and a second source/drain region in a second region in which the second active region is recessed, the second source/drain region connected to the plurality of channel layers on the second active region and having a second conductivity-type, different from the first conductivity-type; first internal spacers between the first gate structure and the first source/drain region, below each of the plurality of channel layers on the first active region; and second internal spacers between the second gate structure and the second source/drain region, below each of the plurality of channel layers on the second active region, each of the first internal spacers may include a spacer dielectric layer and a spacer insulating film between the spacer dielectric layer and the gate structure, and a central thickness of each of the first internal spacers in the first direction may be greater than a central thickness of each of the second internal spacers in the first direction.

According to some aspects of the present disclosure, a semiconductor device may include a substrate including an active region extending in a first direction; a gate structure extending in a second direction intersecting the active region on the substrate; on the active region, a plurality of channel layers spaced apart from each other in a third direction, perpendicular to an upper surface of the substrate, and surrounded by the gate structure; a source/drain region on at least one side of the gate structure and connected to the plurality of channel layers; and internal spacers between the plurality of channel layers and separating the gate structure and the source/drain regions, wherein each of the internal spacers may include a spacer insulating film in contact with the gate structure, a spacer pile-up film in contact with the source/drain region, and a spacer dielectric layer filling a space between the spacer insulating film and the spacer pile-up film, and the spacer dielectric layer may include a material different from the spacer pile-up film and the spacer insulating film.

According to some aspects of the present disclosure, a semiconductor device may include a substrate including a first region and a second region; a first active region extending in a first direction, in the first region on the substrate; a second active region extending in the first direction, in the second region on the substrate; a first gate structure extending on the first active region, in a second direction, intersecting the first direction; a second gate structure extending in the second direction on the second active region; on the first and second active regions, a plurality of channel layers spaced apart from each other in a third direction, perpendicular to an upper surface of the substrate, and surrounded by the gate structure; on both sides of the first gate structure, a first source/drain region in a first region in which the first active region is recessed, the first source/drain region connected to the plurality of channel layers on the first active region and having a first conductivity-type; on both sides of the second gate structure, a second source/drain region in a second region in which the second active region is recessed, the second source/drain region connected to the plurality of channel layers on the second active region and having a second conductivity-type, different from the first conductivity-type; first internal spacers separating the first gate structure and the first source/drain region, below each of the plurality of channel layers on the first active region; and second internal spacers disposed to separate the second gate structure and the second source/drain region, below each of the plurality of channel layers on the second active region, wherein a central thickness of each of the first and second internal spacers in the first direction may be smaller than a top thickness of each of the first and second internal spacers.

A structure or a material of an internal spacer may be optimized or improved according to the source/drain conductivity-type, thereby providing a semiconductor device having improved reliability.

At least some of the above and other features of the invention are set out in the claims.

Advantages and effects of the present application are not limited to the foregoing content and may be more easily understood in the process of describing a specific example embodiment of the present disclosure.

### BRIEF DESCRIPTION OF DRAWINGS

The above and other aspects, features, and advantages of the present disclosure will be more clearly understood from the following detailed description, taken in conjunction with the accompanying drawings, in which:
FIG. 1 is a schematic top view illustrating a semiconductor device according to example embodiments;
FIG. 2 is schematic cross-sectional views illustrating a semiconductor device according to example embodiments;
FIGS. 3A to 3I are partially enlarged views illustrating a semiconductor device according to example embodiments;
FIG. 4 is a schematic top view illustrating a semiconductor device according to example embodiments;
FIG. 5 is schematic cross-sectional views illustrating a semiconductor device according to example embodiments;
FIGS. 6A and 6B are partially enlarged views illustrating a semiconductor device according to example embodiments;
FIGS. 7A to 7E, and 9 are cross-sectional views illustrating a method of manufacturing a semiconductor device according to example embodiments, according to a process sequence; and
FIGS. 8A to 8E are partially enlarged views illustrating a method of manufacturing a semiconductor device according to example embodiments, according to a process sequence.

### DETAILED DESCRIPTION

Hereinafter, example embodiments of the present disclosure will be described with reference to the accompanying drawings. Hereinafter, it may be understood that the expressions such as "on," "above," "upper," "below", "beneath," "lower," and "side," merely indicated based on drawings, except that they are indicated by drawings and referred to separately. That is, directions and relatively locations of features are described with reference to the views shown in the drawings, and need not indicate any particular orientation of the semiconductor device in use. For instance, a vertical direction may be defined perpendicular to an upper surface of a substrate of the semiconductor device. Horizontal directions may be defined parallel to the upper surface of the substrate. Features that are described as being "above" other features may be located further along the vertical direction than the other features.

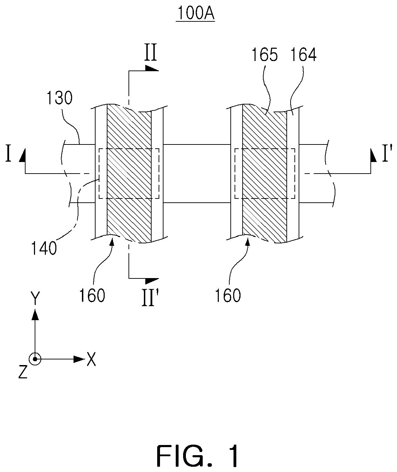

FIG. 1 is a schematic top view illustrating a semiconductor device according to example embodiments. For convenience of explanation, only some components of the semiconductor device are illustrated in FIG. 1.

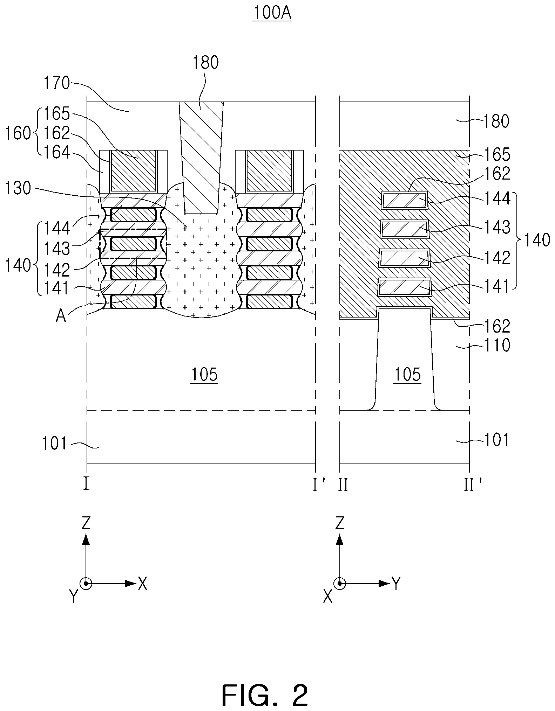

FIG. 2 is schematic cross-sectional views illustrating a semiconductor device according to example embodiments. FIG. 2 schematically illustrates cross-sections of the semiconductor device of FIG. 1 taken along cutting lines I-I' and II-II'.

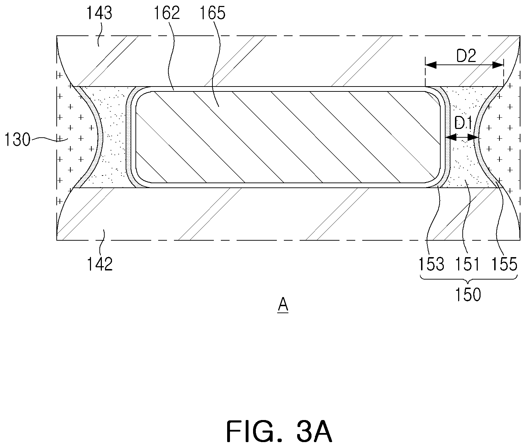

FIG. 3A is partially enlarged view illustrating a semiconductor device according to example embodiments. FIG. 3A illustrates an enlarged view of region 'A' of the semiconductor device of FIG. 2.

Referring to FIGS. 1 to 3A, a semiconductor device 100A may include a substrate 101 including an active region 105, channel structures 140 including first to fourth channel layers 141, 142, 143 and 144 vertically spaced apart from each other on the active region 105, gate structures 160 extending by intersecting the active region 105 and each including a gate electrode 165, source/drain regions 130 in contact with channel structures 140, internal spacers 150 disposed between the gate structure 160 and the source/drain region 130 below each of the channel layers 141, 142, 143 and 144, and a contact structure 180 connected to the source/drain regions 130. The semiconductor device 100A may further include a device isolation layer 110 and an interlayer insulating layer 170.

In the semiconductor device 100A, the active region 105 may have a fin structure, and the gate electrode 165 may be disposed between the active region 105 and the channel structure 140, between the first to fourth channel layers 141, 142, 143 and 144 of the channel structure 140, and on the channel structure 140. Accordingly, the semiconductor device 100A may include transistors having a MBCFET^{™} (Multi Bridge Channel FET) structure, which is a gate-all-around type field effect transistor.

The substrate 101 may have an upper surface extending in an X-direction and a Y-direction. The X-direction and Y-direction may be horizontal directions. The X-direction may intersect (e.g. may be perpendicular to) the Y-direction. The substrate 101 may include a semiconductor material, such as a group IV semiconductor, a group III-V compound semiconductor, or a group II-VI compound semiconductor. For example, examples of the group IV semiconductor may include silicon, germanium, or silicon-germanium. The substrate 101 may be provided as a bulk wafer, an epitaxial layer, a silicon on insulator (SOI) layer, or a semiconductor on insulator (SeOI) layer.

The substrate 101 may include an active region 105 disposed on an upper portion thereof. The active region 105 may be defined by the device isolation layer 110 in the substrate 101 and may be disposed to extend in a first direction, for example, the X-direction. However, depending on the method of explanation, the active region 105 may be described as a separate configuration from the substrate 101. The active region 105 may partially protrude through the device isolation layer 110, and an upper surface of the active region 105 may be disposed on a level higher than of an upper surface of the device isolation layer 110. The active region 105 may be formed as a portion of the substrate 101 or may include an epitaxial layer grown from the substrate 101. However, on both sides of the gate structure 160, the active region 105 may be partially recessed to form recessed regions, and source/drain regions 130 may be disposed in the recessed regions.

In example embodiments, the active region 105 may or may not include a well region including impurities. For example, in the case of a P-type transistor (pFET), the well region may include N-type impurities such as phosphorus (P), arsenic (As), or antimony (Sb), and in the case of an N-type field-effect transistor (nFET), the well region may include P-type impurities such as boron (B), gallium (Ga), and/or indium (In). For example, the well region may be disposed at a predetermined (or, alternatively, desired or selected) depth from the upper surface of the active region 105.

The device isolation layer 110 may define the active region 105 in the substrate 101. For example, the device isolation layer 110 may be formed in a shallow trench isolation (STI) process. The device isolation layer 110 may expose the upper surface of the active region 105 and may partially expose an upper portion. In some example embodiments, the device isolation layer 110 may have a curved upper surface so that the device isolation layer 110 has a higher level as it is adjacent to the active region 105. The device isolation layer 110 may be formed of an insulating material. The device isolation layer 110 may be, for example, an oxide, a nitride, or a combination thereof.

The gate structures 160 may be disposed to extend in a second direction, for example, the Y-direction, by intersecting the active region 105 and the channel structures 140 on the active region 105 and the channel structures 140. Functional channel regions of transistors may be formed in the active region 105 and/or the channel structures 140 that intersect the gate electrodes 165 of the gate structures 160. Each of the gate structures 160 may include a gate electrode 165, gate dielectric layers 162 between the gate electrode 165 and the first to fourth channel layers 141, 142, 143 and 144, and gate spacer layers 164 on side surfaces of the gate electrode 165.

The gate dielectric layers 162 may be disposed between the active region 105 and the gate electrode 165 and between the channel structure 140 and the gate electrode 165, and may be disposed to cover at least some of surfaces of the gate electrode 165. For example, the gate dielectric layers 162 may be disposed to surround all surfaces of the gate electrode 165 except an uppermost surface thereof. The gate dielectric layers 162 may be in contact with internal spacers 150 below the plurality of channel layers 141, 142, 143 and 144, and may be spaced apart from the source/drain regions 130 by the internal spacers 150. The gate dielectric layers 162 may extend between the gate electrode 165 and the gate spacer layers 164, but the present disclosure is not limited thereto. The gate dielectric layers 162 may include an oxide, a nitride, or a high-x material. The high-_{K} material may refer to a dielectric material having a higher dielectric constant than that of a silicon oxide film (SiO₂). The high-x material may be, for example, any one of aluminum oxide (Al₂O₃), tantalum oxide (Ta₂O₃), titanium oxide (TiO₂), yttrium oxide (Y₂O₃), zirconium oxide (ZrO₂), zirconium silicon oxide (ZrSiₓO_{y}), hafnium oxide (HfO₂), hafnium silicon oxide (HfSiₓO_{y}), lanthanum oxide (La₂O₃), lanthanum aluminum oxide (LaAlₓO_{y}), lanthanum hafnium oxide (LaHfₓO_{y}), hafnium aluminum oxide (HfAlₓO_{y}) and praseodymium oxide (Pr₂O₃). According to example embodiments, the gate dielectric layer 162 may be formed of a multilayer film.

The gate electrode 165 may be disposed to fill a space between the first to fourth channel layers 141, 142, 143 and 144 on the active region 105 and extend onto the channel structure 140. The gate electrode 165 may be spaced apart from the first to fourth channel layers 141, 142, 143 and 144 by the gate dielectric layers 162. The gate electrode 165 may include a conductive material, for example, a metal nitride such as titanium nitride (TiN), tantalum nitride (TaN), or tungsten nitride (WN), and/or a metal material such as aluminum (Al), tungsten (W), or molybdenum (Mo) or a semiconductor material such as doped polysilicon. According to example embodiments, the gate electrode 165 may be formed of two or more multiple layers.

The gate spacer layers 164 may be disposed on both side surfaces of the gate electrode 165 on the channel structure 140. The gate spacer layers 164 may insulate the source/drain regions 130 and the gate electrode 165. The gate spacer layers 164 may have a multilayer structure, according to example embodiments. The gate spacer layers 164 may be formed of at least one of an oxide, a nitride, and/or an oxynitride, and may be formed of, for example, a low dielectric constant film.

The channel structures 140 may be disposed on the active region 105, in regions in which the active region 105 intersects the gate structures 160. Each of the channel structures 140 may include first to fourth channel layers 141, 142, 143 and 144, which are a plurality of channel layers spaced apart from each other in a Z-direction. The first to fourth channel layers 141, 142, 143 and 144 may be disposed sequentially from an upper portion, and the first channel layer 141 may be an uppermost channel layer. The channel structures 140 may be connected to source/drain regions 130. The channel structures 140 may have a width equal to or similar to the gate structures 160 in the X-direction, and may have a width equal to or smaller than that of the active region 105 in the Y-direction. In a cross-section taken in the Y-direction, a channel layer disposed in a lower portion of the first to fourth channel layers 141, 142, 143 and 144 may have a width equal to or larger than that of the channel layer disposed in the upper portion. The number and shape of channel layers forming one channel structure 140 may change variously in example embodiments. For example, one channel structure 140 may include three channel layers, and may include two channel layers or may include five or more channel layers.

The channel structures 140 may be formed of a semiconductor material, and may include, for example, at least one of silicon (Si), silicon germanium (SiGe), and germanium (Ge). For example, the channel structures 140 may be formed of the same material as the active region 105. In some example embodiments, the channel structures 140 may include an impurity region disposed adjacently to the source/drain regions 130.

The source/drain regions 130 may be disposed in recessed regions in which an upper portion of the active region 105 is partially recessed on both sides of the gate structure 160. The recessed regions may extend along side surfaces of the channel structures 140 and side surfaces of the gate dielectric layers 162. The source/drain regions 130 may be disposed to cover side surfaces of each of the first to fourth channel layers 141, 142, 143 and 144 of the channel structures 140 in the X-direction. Upper surfaces of the source/drain regions 130 may be disposed on a level equal to or higher than that of lower surfaces of the gate electrodes 165 on the channel structures 140, and the level may change variously in example embodiments. Side surfaces of the source/drain regions 130 may be curved according to the first to fourth channel layers 141, 142, 143 and 144 and the internal spacers 150. The side surfaces of the source/drain regions 130 may protrude in a direction of the gate structure 160 between the plurality of channel layers 141, 142, 143 and 144. However, the specific shapes of the side surfaces of the source/drain regions 130 may change variously in example embodiments. The source/drain regions 130 may be epitaxially grown regions, and may include a plurality of epitaxial layers. An epitaxially grown surface of the source/drain regions 130 may be in contact with the channel structures 140, the internal spacers 150, and the interlayer insulating layer 170.

The source/drain regions 130 may include a semiconductor material, for example, at least one of silicon (Si) and germanium (Ge), and may further include dopants. For example, when the semiconductor device 100A is an nFET, the dopants may be at least one of phosphorus (P), arsenic (As), and antimony (Sb). For example, when the semiconductor device 100A is a pFET, the dopants may be at least one of boron (B), gallium (Ga), and/or indium (In). According to example embodiment, the source/drain regions 130 may be formed of a plurality of epitaxial layers.

The interlayer insulating layer 170 may be disposed on the device isolation layer 110 to cover an upper surface of the device isolation layer 110 and the source/drain region 130. The interlayer insulating layer 170 may include at least one of an oxide, a nitride, and/or an oxynitride, and may include, for example, a low dielectric constant material. According to example embodiments, the interlayer insulating layer 170 may include a plurality of insulating layers.

The internal spacers 150 may be disposed between the gate structure 160 and the source/drain region 130, below each of the plurality of channel layers 141, 142, 143 and 144 on the active region 105. The internal spacers 150 may be disposed parallel to the gate electrode 165 between the first to fourth channel layers 141, 142, 143 and 144 in the third direction (here, the Z-direction). The internal spacers 150 may cover side surfaces of the gate structure 160 below the channel structure 140 in the X-direction. For FIG. 3A, region 'A' between the second channel layer 142 and the third channel layer 143 is illustrated as being enlarged, but this is an example, and the internal spacers 150 below the other plurality of channel layers 141, 142, 143 and 144 may have characteristics identical to or similar to the internal spacers 150, which are described with reference to FIG. 3A. The gate electrode 165 may be stably spaced from the source/drain region 130 by the internal spacers 150, and may be electrically separated (e.g. electrically insulated). The internal spacers 150 below the second to fourth channel layers 142, 143 and 144 may be understood as being disposed between adjacent channel layers, and the internal spacers 150 below the first channel layer 141 may be understood as being disposed between the first channel layer 141 and the active region 105. An upper end and a lower end of side surfaces of the internal spacers 150 facing the gate electrode 165 may have a shape protruding toward the gate electrode 165. The internal spacers 150 may have concave side surfaces toward the gate electrode 165 (e.g. the side surfaces of the internal spacers 150 that face away from the gate electrode 165 may be concave - they may be recessed towards the gate electrode 165). That is, the source/drain regions 130 may have a convex shape toward the internal spacers 150. As a side surface of the source/drain region 130 has a shape protruding in a direction of the gate electrode 165 between the plurality of channel layers 141, 142, 143 and 144, a side surface of the internal spacers 150 which is in contact with the source/drain region 130 may have a concavely rounded shape toward the source/drain region 130. In the first direction (here, the X-direction), a central thickness D1 of each of the internal spacers 150 may be smaller than a top thickness D2 of each of the internal spacers 150. The central thickness D1 of each of the internal spacers 150 may be a minimum thickness, and the top thickness D2 may be a maximum thickness. The term central thickness D1 in this context may refer to a thickness of the internal spacers 150 at a middle point between the top and bottom of the internal spacers 150 (e.g. central along the vertical direction). In some example embodiments, the central thickness D1 of each of the internal spacers 150 may be about or exactly 1 nm to about or exactly 3 nm, and in some example embodiments, the central thickness D1 may be about or exactly 1.5 nm to about or exactly 2.5 nm. Depending on the shape of the source/drain region 130, a processing method and an order of the internal spacers 150, and the like, the shape of the internal spacers 150 may be modified in various manners.

Each internal spacer 150 may include a spacer dielectric layer 151, a spacer insulating film 153 in contact with the gate structure 160, and a spacer pile-up film 155 in contact with the source/drain region 130.

The spacer dielectric layer 151 may be in contact with adjacent channel layers (for example, in the case of FIG. 3A, the second channel layer 142 and the third channel layer 143). The spacer dielectric layer 151 may be spaced apart from the gate structure 160 by the spacer insulating film 153, and may be spaced apart from the source/drain region 130 by the spacer pile-up film 155. The spacer dielectric layer 151 may include an insulating material and may include at least one of an oxide, a nitride, and/or an oxynitride.

The spacer insulating film 153 may be disposed on a side surface of the spacer dielectric layer 151 facing the gate structure 160, and may be in contact with gate structure 160. The spacer insulating film 153 may include an insulating material and may include at least one of an oxide, a nitride, and/or an oxynitride. The spacer insulating film 153 may include a material different from that of the spacer dielectric layer 151. For example, the spacer dielectric layer 151 may include silicon oxide (SiO), and the spacer insulating layer 153 may include at least one of silicon nitride (SiN) and silicon oxynitride (SiON).

The spacer pile-up film 155 may be disposed on a side surface of the spacer dielectric layer 151 facing the source/drain region 130, and may be in contact with the source/drain region 130. The spacer pile-up film 155 may extend along a surface of the source/drain region 130 between the plurality of channel layers 141, 142, 143 and 144. The spacer dielectric layer 151 may be spaced apart from the source/drain region 130 by the spacer pile-up film 155. The spacer pile-up film 155 may include an insulating material, and may include at least one of an oxide, a nitride, and/or an oxynitride. The spacer pile-up film 155 may include a different material from the spacer dielectric layer 151 and may include the same material as the spacer insulating film 153. For example, the spacer dielectric layer 151 may include silicon oxide (SiO), and the spacer insulating film 153 and the spacer pile-up film 155 may include at least one of silicon nitride (SiN) and silicon oxynitride (SiON).

As the internal spacers 150 that may allow the gate electrode 165 and the source/drain region 130 to be electrically separated include a spacer dielectric layer 151, a spacer insulating film 153, and a spacer pile-up film 155, the gate electrode 165 and the source/drain region 130 may be stably separated from each other, and the internal spacers 150 may have an appropriate thickness depending on the conductivity-type of the source/drain region 130. Accordingly, a semiconductor device having improved reliability may be provided.

The contact structure 180 may be disposed on source/drain region 130. The contact structure 180 may be connected to the source/drain region 130 and may apply an electrical signal to the source/drain region 130. The contact structure 180 may recess the source/drain regions 130 and may extend into source/drain region 130. The contact structure 180 may have an inclined side surface so that a width thereof decreases toward the substrate 101 due to an aspect ratio, but the present disclosure is not limited thereto. As in some example embodiments, the contact structure 180 may extend below a lower surface of one of the channel layers 141, 142, 143 and 144. For instance, the contact structure 180 may extend below a lower surface of a fourth channel layer 144, which is a fourth channel layer, and according to some example embodiments, the contact structure 180 may extend below a lower surface of a second channel layer 142 or a third channel layer 143. For example, the contact structure 180 may include a metal material such as tungsten (W), cobalt (Co), molybdenum (Mo), copper (Cu), ruthenium (Ru), or aluminum (Al).

In the description of the following embodiments, descriptions overlapping those described above with reference to FIGS. 1 to 3A will be omitted.

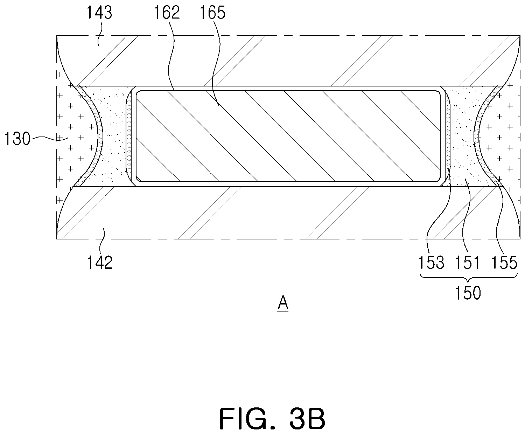

FIGS. 3B to 3I are partially enlarged views illustrating semiconductor devices according to example embodiments. FIGS. 3B to 3I illustrate enlarged regions corresponding to a region illustrated by enlarging region 'A' of the semiconductor device in FIG. 2, and illustrate modified embodiments of FIG. 3A. A specific form of the internal spacers 150 is not limited to the example embodiments of FIGS. 3A to 3I.

Referring to FIG. 3B together with FIG. 2, the spacer insulating film 153 may cover a portion of a side face of the spacer dielectric layer 151 facing the gate electrode 165, and the spacer dielectric layer 151 may be in contact with the gate dielectric layer 162 of the gate structure 160. The spacer insulating film 153 may cover the remaining portion of the spacer dielectric layer 151 except for an upper portion and a lower portion of a side surface facing the gate electrode 165. The spacer dielectric layer 151 may contact the gate dielectric layer at the upper portion and lower portion of the side surface facing the gate electrode 165. A thickness of the spacer insulating film 153 may change depending on the level. In some example embodiments, the spacer insulating layer 153 may become thinner as it approaches an adjacent channel layer, in a third direction (here, the Z-direction).

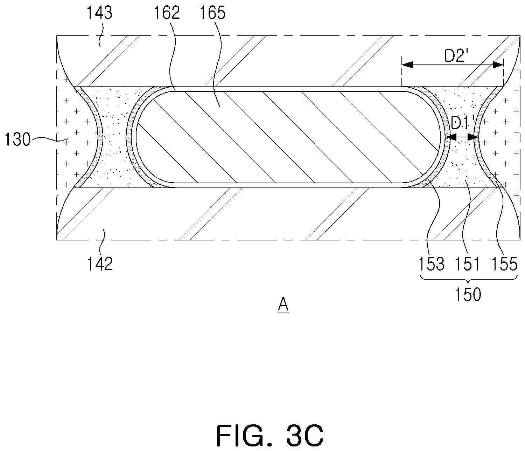

Referring to FIG. 3C together with FIG. 2, a side surface of the internal spacer 150 facing the gate electrode 165 may have a concave and rounded shape toward the gate electrode 165 (e.g. the side surface of the internal spacer 150 facing the gate electrode 165 may be concave). That is, the gate electrode 165 may have a convex and rounded shape toward the internal spacers 150. A top thickness D2' of the internal spacer 150 may be greater than a central thickness D1' of the internal spacer 150, and a difference between the top thickness D2' and the central thickness D1' may be greater in the example embodiments of FIG. 3C than in some example embodiments of FIG. 3A.

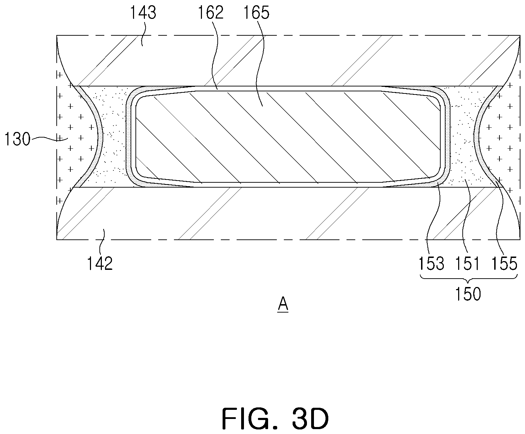

Referring to FIG. 3D, an upper portion of a gate insulating film 153 may partially extend along a lower surface of an adjacent channel layer (e.g., the third channel layer 143). A portion of an upper surface of the gate dielectric layer 162 may be in contact with a lower surface of a channel layer (e.g., the third channel layer 143), and the remaining portion may be in contact with the gate insulating film 153. A lower portion of the gate insulating layer 153 may partially extend along an upper surface of an adjacent channel layer (e.g., the second channel layer 142). A portion of a lower surface of the gate insulating film 153 may be in contact with an upper surface of the channel layer (e.g., the second channel layer 142), and the remaining portion may be in contact with the gate insulating film 153. Referring to FIG. 2 together, in the case of the internal spacer 150 disposed below the first channel layer 141, a lower portion of the spacer insulating film 153 may partially extend along the upper surface of the active region 105.

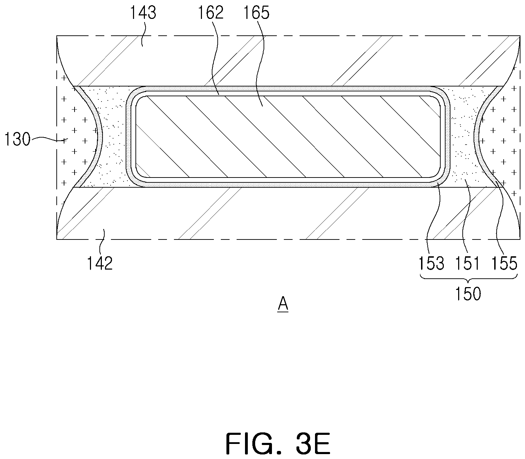

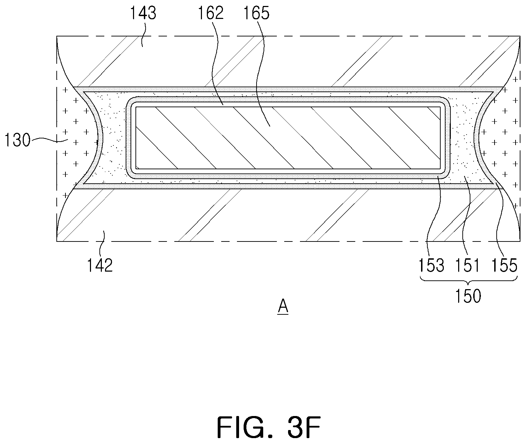

Referring to FIG. 3E, the internal spacer 150 may be shaped to surround the gate electrode 165 on the same level. The gate insulating film 153 may extend along a surface of the gate dielectric layer 162 below each of the channel layers 141, 142, 143 and 144, and may surround the gate electrode 165 in contact. The spacer insulating film 153 may surround the gate structure 160 between the plurality of channel layers 141, 142, 143 and 144. The gate dielectric layer 162 may not be in contact with adj acent channel layers due to the gate insulating layer 153. Hereinafter, FIGS. 3F to 3G illustrate example embodiments in which the internal spacer 150 surrounds the gate electrode 165 in contact.

Referring to FIG. 3F, unlike the example embodiment of FIG. 3E, in addition to the spacer insulating film 153 of the internal spacer 150, the spacer dielectric layer 151 and the spacer pile-up film 155 may also surround an adjacent gate electrode 165. A thickness of the internal spacer 150 covering an upper surface and a lower surface of the adjacent gate electrode 165 may be smaller than a thickness covering both sides of the gate electrode 165.

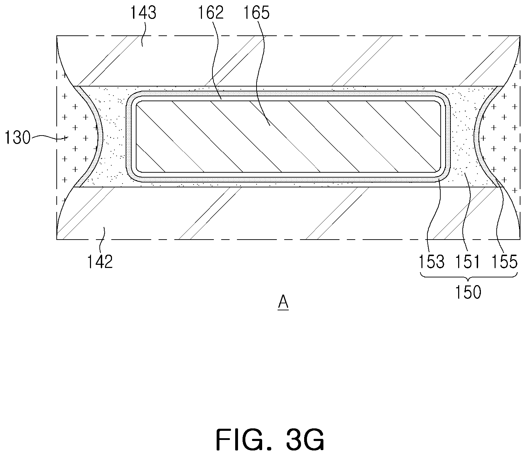

Referring to FIG. 3G, unlike the example embodiment of FIG. 3F, the spacer insulating film 153 and the spacer dielectric layer 151 of the internal spacer 150 may surround the adjacent gate electrode 165, and a spacer pile-up film 155 may cover a side surface of the gate dielectric layer 151 facing the source/drain region 130.

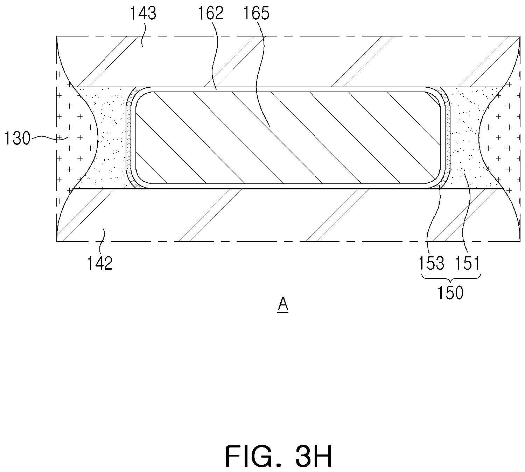

Referring to FIG. 3H, unlike the example embodiment of FIGS. 3A to 3G, the internal spacer 150 may not include the spacer pile-up film 155. Accordingly, the spacer dielectric layer 151 may be in direct contact with the source/drain region 130.

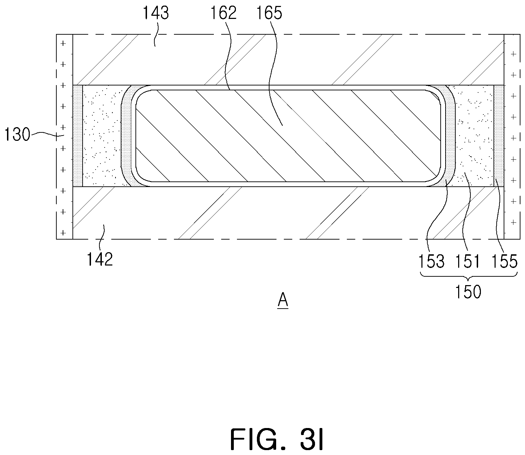

Referring to FIG. 3I, unlike the example embodiment of FIGS. 3A to 3H, a side surface of the source/drain region 130 may not protrude toward the gate electrode 165 between each of the channel layers 141, 142, 143 and 144. Accordingly, a side surface of the internal spacer 150 in contact with the source/drain region 130 may be formed along the side surface of the source/drain region 130 and may have a flat shape.

The example embodiments of FIGS. 3A to 3I described above are examples of particular implementations, the detailed configuration and arrangement relationship of the gate structure 160 including the gate electrode 165, the source/drain region 130 and the internal spacer 150, the contact relationship thereof, the thickness or the presence or absence of each component, and the like, are not limited thereof, and may be modified in various manner. For example, the spacer pile-up film 155 may cover only a portion of the side surface of the source/drain region 130 in contact with the internal spacers 150. Additionally, for example, the presence or absence of the spacer pile-up film 155 and a thickness thereof may be changed even among the internal spacers 150 on the same level. According to some example embodiments, each of the internal spacers 150 below the plurality of channel layers 141, 142, 143 and 144 may have a form of one of the embodiments of FIGS. 3A to 3I, and modified example thereof. That is, the internal spacers 150 may be present in different forms.

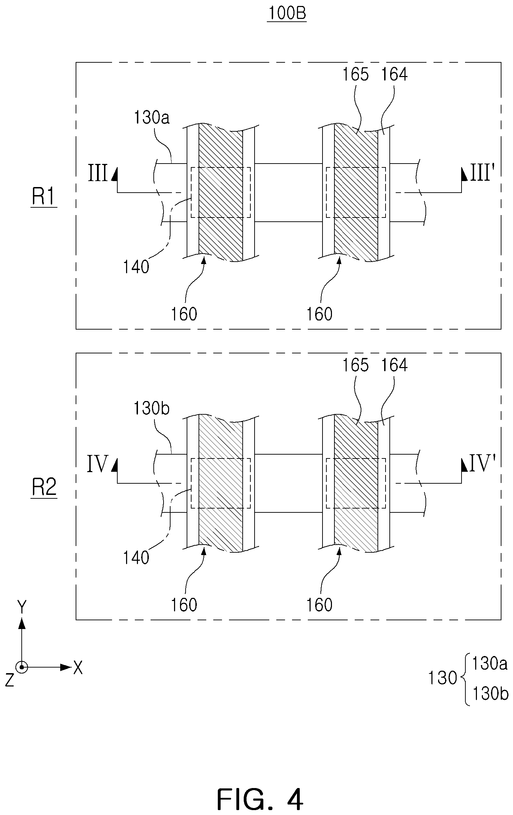

FIG. 4 is a schematic top view illustrating a semiconductor device according to example embodiments. For convenience of explanation, only some components of the semiconductor device are illustrated in FIG. 4.

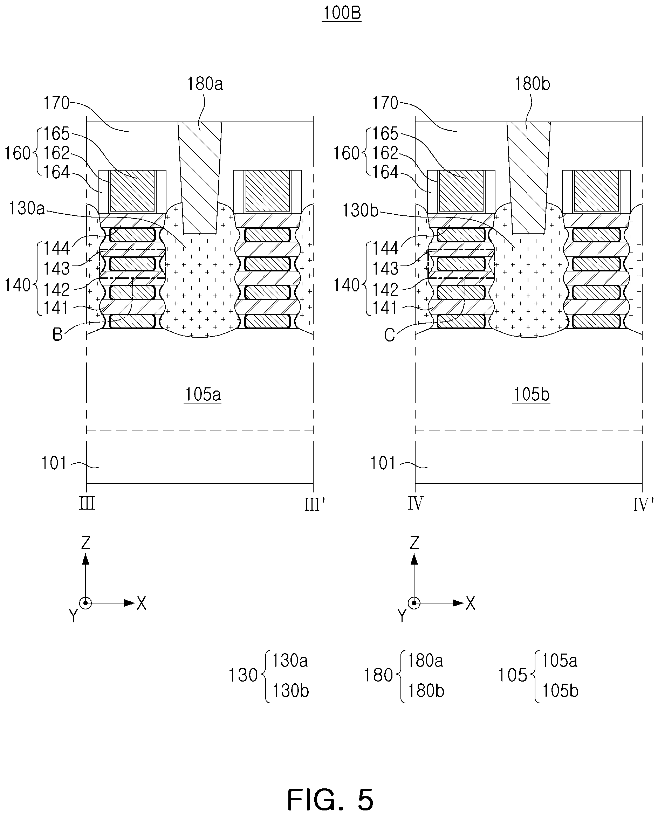

FIG. 5 is a schematic cross-sectional view illustrating a semiconductor device according to example embodiments. FIG. 5 schematically illustrates cross-sections of the semiconductor device of FIG. 4 taken along cutting lines III-III' and IV-IV'.

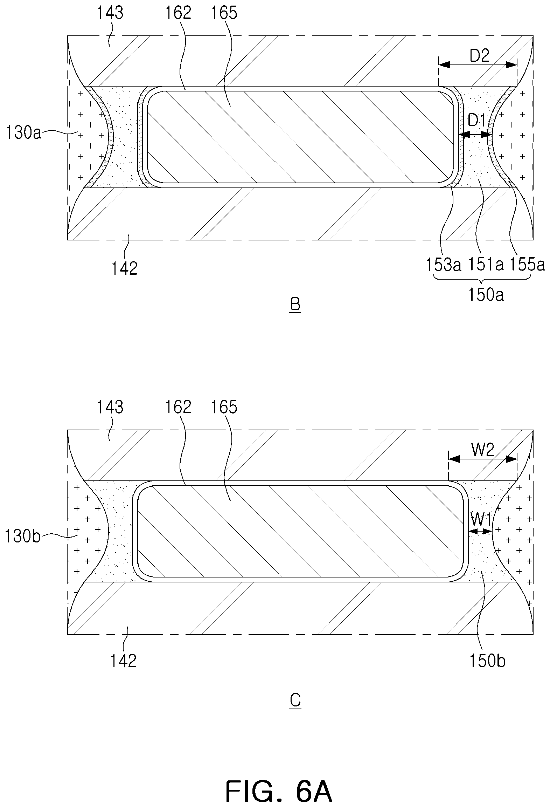

FIG. 6A is a partially enlarged view illustrating a semiconductor device according to example embodiments. FIG. 6A illustrates an enlarged view of region 'B' and region 'C' of the semiconductor device of FIG. 5.

Referring to FIGS. 4 to 6A, a semiconductor device 100B may include a first region R1 and a second region R2 having different conductivity-types. According to some example embodiments, the first region R1 and the second region R2 may be adjacent to each other or may be spaced apart from each other. According to some example embodiments, the gate structure 160 in the first region R1 may extend into the second region R2. Depending on the description method, a gate structure 160 in the first region R1 may be referred to as a first gate structure 160, and a gate structure 160 in the second region R2 may be referred to as a second gate structure 160. According to some example embodiments, the first gate structure 160 in the first region R1 and the second gate structure 160 in the second region R2 may be of separate configuration, and may be configured to extend and continue in a second direction (here, the Y-direction). Each component in the first region R1 may have the characteristics identical to or similar to each component described with reference to FIGS. 1 to 3A. Overlapping descriptions thereof will be omitted.

A first source/drain region 130a in the first region R1 may have a first conductivity-type, and a second source/drain region 130b in the second region R2 may have a second conductivity-type, different from the first conductivity-type. For example, the first source/drain region 130a having a first conductivity-type may be an N-type, and the first source/drain region 130a may include at least one dopant selected from phosphorus (P), arsenic (As), and/or antimony (Sb). For example, the second source/drain region 130b having a second conductivity-type may be a P-type, and the second source/drain region 130b may include at least one dopant selected from boron (B), gallium (Ga), and/or indium (In).

First internal spacers 150a may be disposed between the gate structure 160 and the first source/drain region 130a, below each of the plurality of channel layers 141, 142, 143, and 144 on the first active region 105a, in the first region R1. The first internal spacers 150a may be parallel to a gate electrode 165 between the first to fourth channel layers 141, 142, 143 and 144 in a third direction (here, the Z-direction). The first internal spacers 150a may cover side surfaces of the first gate structure 160 below the channel structure 140 in the X-direction. The gate electrode 165 may be stably spaced from the first source/drain region 130a by the internal spacers 150, and may be electrically separated therefrom. Internal spacers 150 below the second to fourth channel layers 142, 143 and 144 may be understood as being disposed between adjacent channel layers, and internal spacers 150 below the first channel layer 141 may be understood as being disposed between the first channel layer 141 and the first active region 105a. The first internal spacers 150a may have the characteristics identical to or similar to the internal spacers 150 described with reference to FIGS. 3A to 3I. For example, in some example embodiments, a central thickness D1 of each of the first internal spacers 150a may be about or exactly 1 nm to about or exactly 3 nm, and in some example embodiments, the central thickness D1 of each of the first internal spacers 150a may be about or exactly 1.5 nm to about or exactly 2.5 nm.

The second internal spacers 150b may be disposed between the second gate structure 160 and the second source/drain region 130b, below each of the plurality of channel layers 141, 142, 143 and 144 on the second active region 105b, in the second region R2. The second internal spacers 150b may be parallel to the gate electrode 165 between the first to fourth channel layers 141, 142, 143 and 144, in the third direction (here, the Z-direction). The second internal spacers 150b may cover side surfaces of the second gate structure 160 below the channel structure 140 in the X-direction. Unlike the first internal spacers 150a, the second internal spacers 150b may not include a spacer insulating film 153a and a spacer pile-up film 155b included in the first internal spacer 150a. In some example embodiments, the second internal spacers 150b may include an insulating material such as silicon oxide. The central thickness D1 of the first internal spacer 150a may be greater than a central thickness W1 of the second internal spacer 150b, and a top thickness D2 of the first internal spacer 150a may be greater than the top thickness W2 of the second internal spacer 150b. In some example embodiments, the central thickness W1 of each of the second internal spacers 150b may be about or exactly 0.5 nm to about or exactly 2 nm, and in some example embodiments, the central thickness W1 of each of the second internal spacers 150b may be about or exactly 0.7 nm to about or exactly 1.5 nm. The second internal spacer 150b may have similar characteristics to the first internal spacer 150a, except for characteristics different from the first internal spacer 150a described above.

In a case in which the semiconductor device 100B includes a plurality of source/drain regions 130 having different conductivity-types, the optimized (or alternatively, improved, desired, or selected) shapes of the internal spacers 150a and 150b disposed between the gate electrode 165 and the source/drain region 130 may be different from each other. For example, in the case of the first internal spacers 150a in contact with the first source/drain region 130a having an N-type conductivity, it may be desirable to separate the gate electrode 165 and the first source/drain region 130a more reliably than the second internal spacers 150b in contact with the second source/drain region 130b having a P-type conductivity-type. Accordingly, unlike the second internal spacers 150b, the first internal spacers 150a may further include a plurality of insulating material layers, such as a first spacer insulating film 153a and a spacer pile-up film 155a, and/or a central thickness D1 and a top thickness D2 of the first internal spacer 150 may be greater than the central thickness W1 and the top thickness W2 of the second internal spacer 150b, respectively. The first internal spacers 150a and the second internal spacers 150b optimized or improved for each conductivity-type may be disposed to improve reliability of the semiconductor device.

In some example embodiments, the first source/drain region 130a in the first region R1 and the second source/drain region 130b in the second region R2 may have the same conductivity-type. Even if the conductivity-type of the first source/drain region 130a with which the first internal spacer 150a is in contact and the second source/drain region 130b with which the second internal spacer 150b is in contact is identical, the first and second internal spacers 150a and 150b may have different configurations and shapes, as desired.

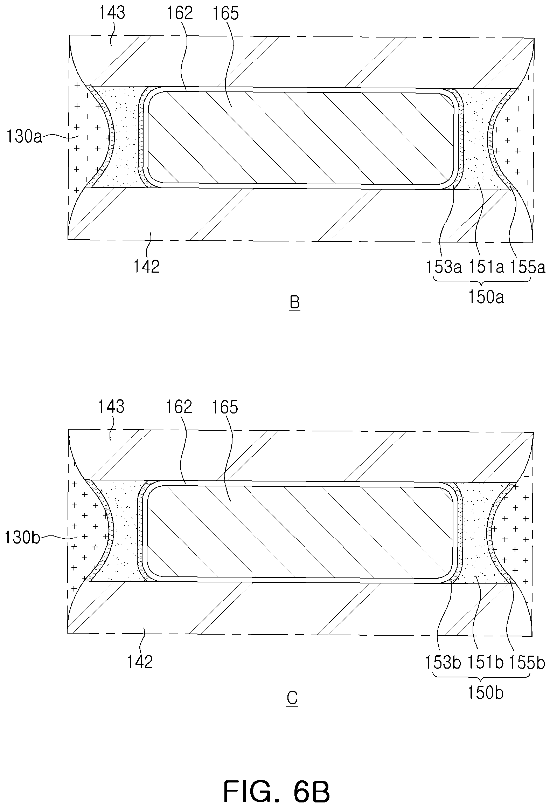

FIG. 6B is a partially enlarged view illustrating a semiconductor device according to example embodiments. FIG. 6B illustrates enlarged regions corresponding to regions illustrated by enlarging region 'B' and region 'C' of the semiconductor device in FIG. 5, and illustrate modified embodiment of FIG. 6A.

Referring to FIG. 6B, the second internal spacers 150b may include a spacer dielectric layer 151b, a spacer insulating film 153b, and a spacer pile-up film 155b, and may have substantially the same or the same shape as the first internal spacers 150a. According to some example embodiments, the second internal spacers 150b may have the form of the internal spacers 150 described with reference to FIGS. 3A to 3I. The second internal spacers 150b do not necessarily have a different shape from the first internal spacers 150a, and an in some example embodiments of the present disclosure, the second internal spacers 150b may have the characteristics identical to or similar to the first internal spacers 150a, as desired, such as simplification of a process.

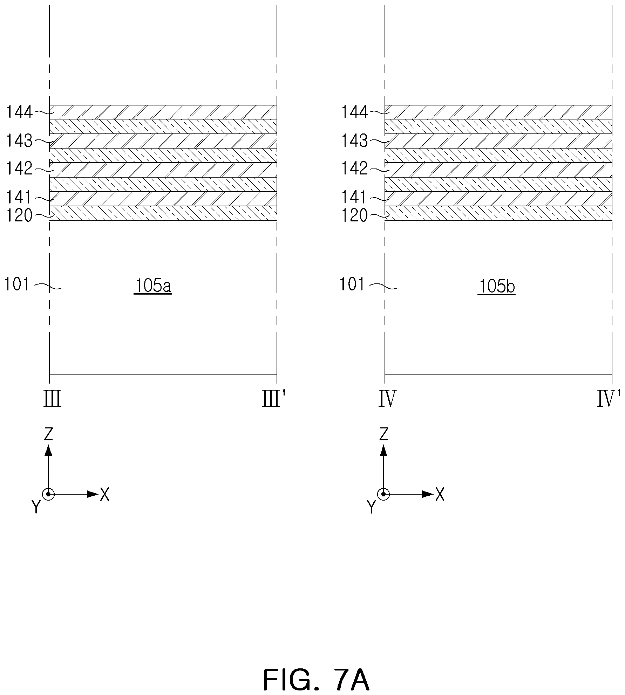

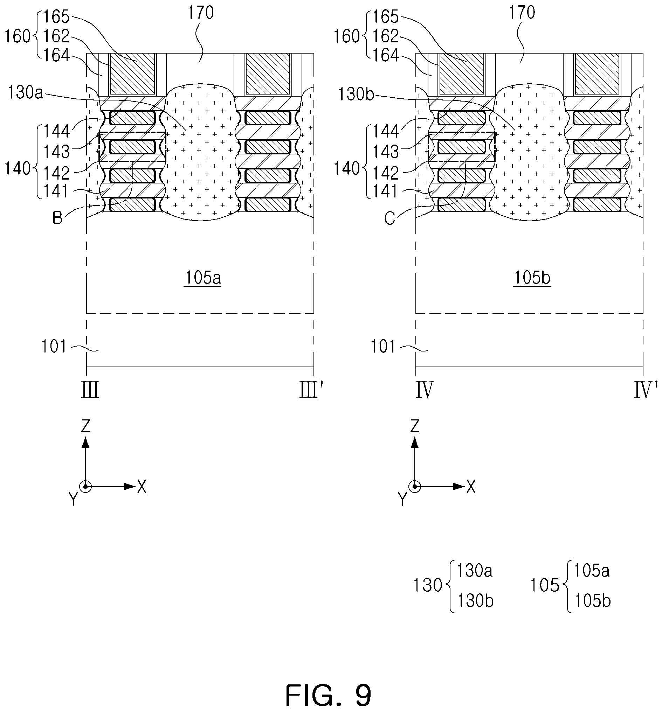

FIGS. 7A to 7E and FIG. 9 are cross-sectional views illustrated according to a process sequence to explain a method of manufacturing a semiconductor device according to example embodiments. FIGS. 7A to 7E and FIG. 9 illustrate cross-sections corresponding to FIG. 5.

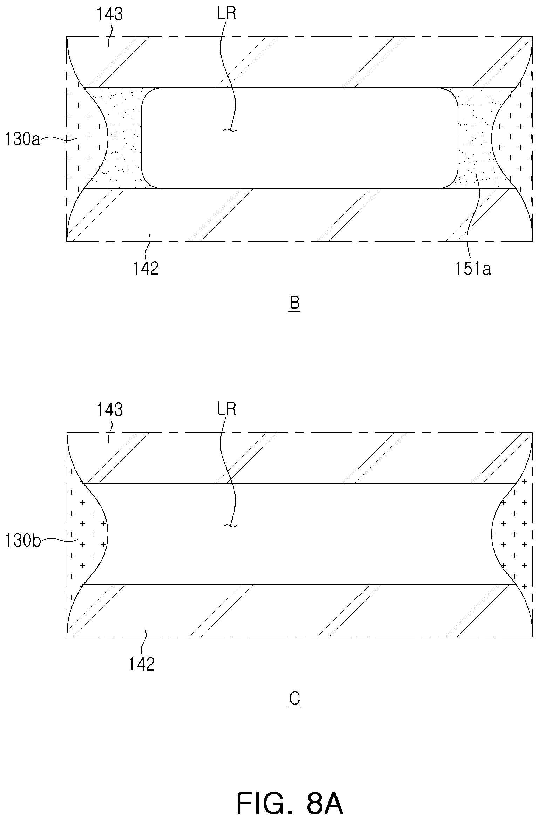

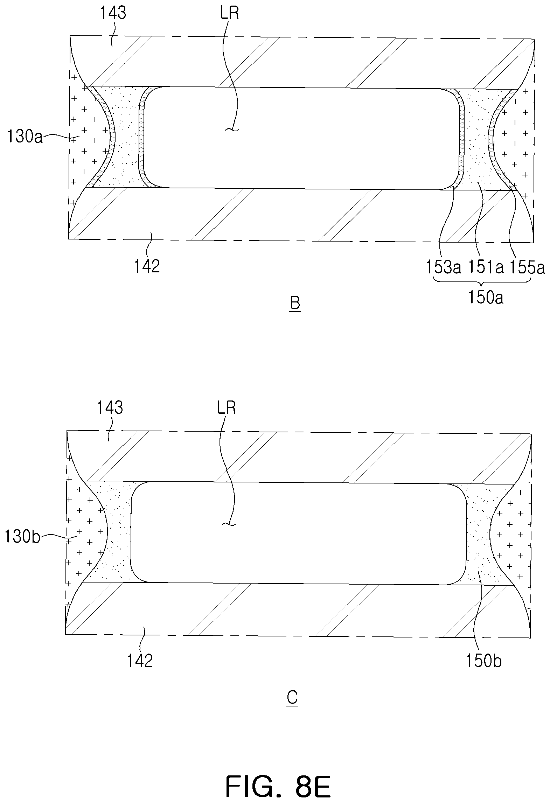

FIGS. 8A to 8E are partially enlarged views illustrating a process sequence to explain a method of manufacturing a semiconductor device according to example embodiments. FIGS. 8A to 8E illustrate enlarged views corresponding to FIG. 6A.

Except where otherwise stated, the process may be understood as proceeding in the order of drawing reference numerals.

Referring to FIG. 7A, a plurality of sacrificial layers 120 and a plurality of channel layers 141, 142, 143 and 144 may be alternately stacked on a substrate 101.

The substrate 101 may include silicon (Si), germanium (Ge), or silicon germanium (SiGe). The substrate 101 may include a bulk wafer, an epitaxial layer, a silicon on insulator (SOI) layer, or a semiconductor on insulator (SeOI) layer.

The plurality of channel layers 141, 142, 143 and 144 may include first to fourth channel layers 141, 142, 143 and 144. The sacrificial layers 120 may be layers that are replaced with gate dielectric layers 162 and gate electrodes 165 below the fourth channel layer 144, through a subsequent process, as illustrated in FIG. 5. The sacrificial layers 120 may be formed of a material having etch selectivity with respect to the first to fourth channel layers 141, 142, 143 and 144, respectively. The first to fourth channel layers 141, 142, 143 and 144 may include a material different from the sacrificial layers 120. The sacrificial layers 120 and the first to fourth channel layers 141, 142, 143 and 144 include, for example, a semiconductor material including at least one of silicon (Si), silicon germanium (SiGe), and germanium (Ge), but may include different material, and may or may not include impurities. For example, the sacrificial layers 120 may include silicon germanium (SiGe), and the first to fourth channel layers 141, 142, 143 and 144 may include silicon (Si).

The sacrificial layers 120 and the first to fourth channel layers 141, 142, 143 and 144 may be formed by performing an epitaxial growth process from the stacked structure. The number of sacrificial layers 120 and the number of channel layers alternately stacked may change variously in example embodiments.

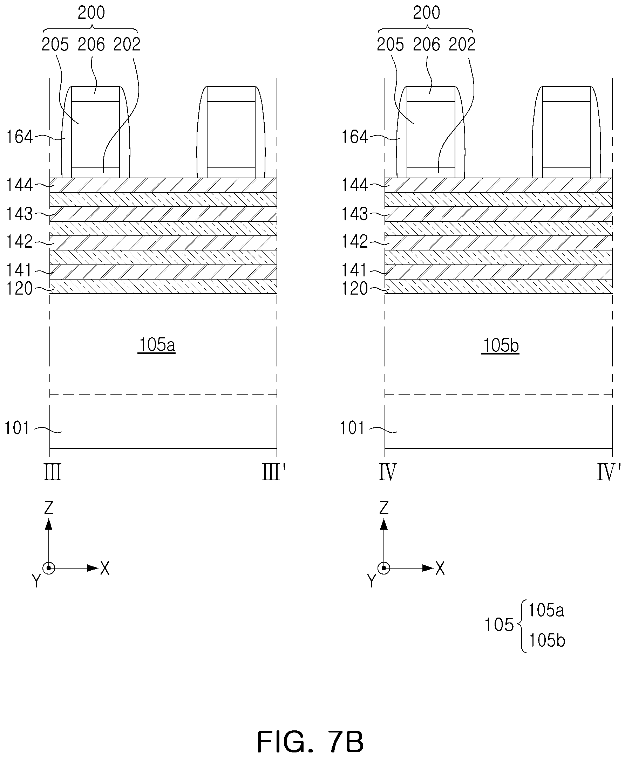

Referring to FIG. 7B, an active structure including an active region 105 may be formed by partially removing the sacrificial layers 120, the first to fourth channel layers 141, 142, 143 and 144, and the substrate 101, a device isolation layer 110 (see FIG. 2) may be formed, and sacrificial gate structures 200 and gate spacer layers 164 may be formed on the active structure.

The active structure may include an active region 105, sacrificial layers 120, and first to fourth channel layers 141, 142, 143 and 144. The active structure may be formed in the form of a line extending in one direction, for example, the X-direction, and may be formed to be spaced apart from adjacent active structures in the Y-direction. Side surfaces of the active structure in the Y-direction may be coplanar with each other and may be disposed on a straight line.

In a region from which a portion of each of the active region 105, the sacrificial layers 120, and the first to fourth channel layers 141, 142, 143 and 144 are removed, the device isolation layer 110 may be formed by burying an insulating material and partially removing the insulating material so that the active region 105 protrudes. An upper surface of the device isolation layer 110 may be formed to be lower than an upper surface of the active region 105.

Each of the sacrificial gate structures 200 may be a sacrificial structure formed through a subsequent process in a region in which the gate dielectric layers 162 and the gate electrode 165 are disposed on the channel structure 140, as illustrated in FIG. 5. The sacrificial gate structures 200 may have a line shape that extends in one direction by intersecting the active structure. The sacrificial gate structures 200 may extend, for example, in the Y-direction. Each of the sacrificial gate structures 200 may include first and second sacrificial gate layers 202 and 205 and a mask pattern layer 206 that are sequentially stacked. The first and second sacrificial gate layers 202 and 205 may be patterned using the mask pattern layer 206.

The first and second sacrificial gate layers 202 and 205 may be an insulating layer and a conductive layer, respectively, but the present disclosure is not limited thereto, and the first and second sacrificial gate layers 202 and 205 may be formed as a single layer. For example, the first sacrificial gate layer 202 includes silicon oxide, and the second sacrificial gate layer 205 may include polysilicon. The mask pattern layer 206 may include silicon oxide and/or silicon nitride.

Gate spacer layers 164 may be formed on both sidewalls of the sacrificial gate structures 200. The gate spacer layers 164 may be form of a low-x material, and may include, for example, at least one of SiO, SiN, SiCN, SiOC, SiON, and SiOCN.

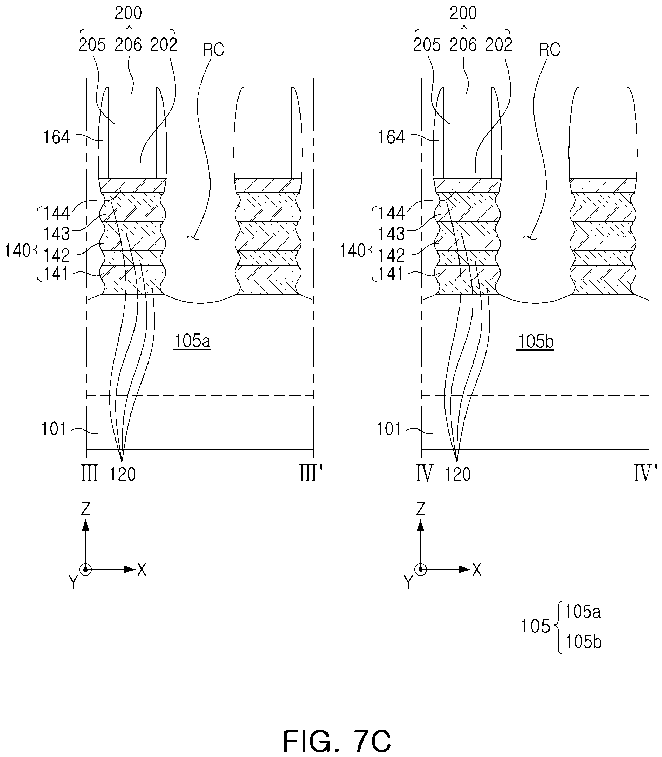

Referring to FIG. 7C, an etching process may be performed using the sacrificial gate structures 200 as an etch mask, and may penetrate through an active structure, thus forming recessed regions exposing an active region 105.

The sacrificial layers 120 and the first to fourth channel layers 141, 142, 143 and 144 exposed from the sacrificial gate structures 200 may be partially removed to form recessed regions and to remove some of the sacrificial layers 120. As a result, the first to fourth channel layers 141, 142, 143 and 144 may form channel structures 140 having a limited length in the X-direction.

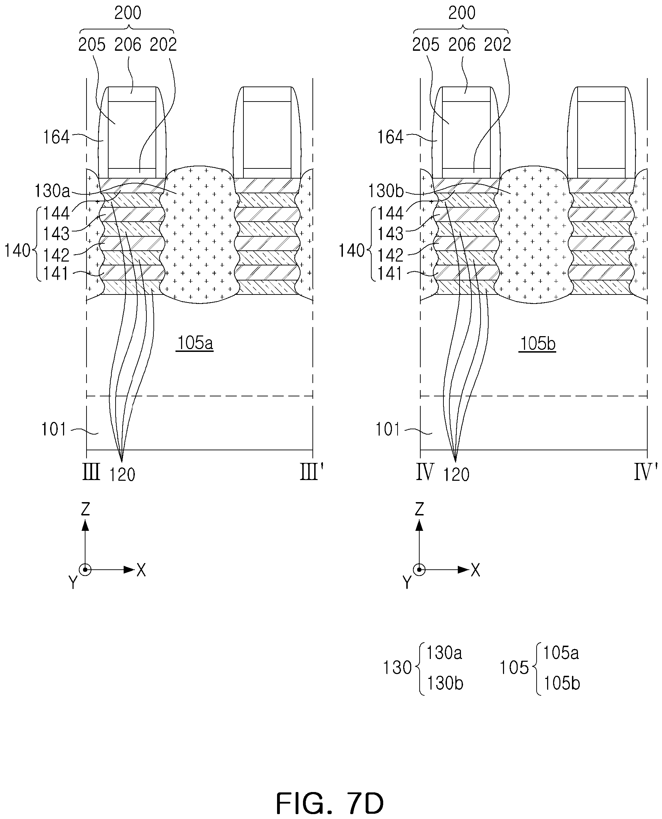

Referring to FIG. 7D, a plurality of source/drain regions 130 may be formed in the recess regions.

Source/drain regions 130 may formed in the recess regions, and may be formed by growing from side surfaces of the active regions 105 and the channel structures 140 by, for example, a selective epitaxial process. The source/drain regions 130 may include a plurality of epitaxial layers, and these epitaxial layers may have different non-silicon concentrations. The source/drain regions 130 may include impurities by in-situ doping, and may include a plurality of layers having different doping elements and/or doping concentrations. The first source/drain regions 130a may have an N-type conductivity-type, and may be formed to include at least one dopant of phosphorus (P), arsenic (As), and/or antimony (Sb). The second source/drain region 130b may have a P-type conductivity-type, and may be formed to include at least one dopant of boron (B), gallium (Ga), and/or indium (In).

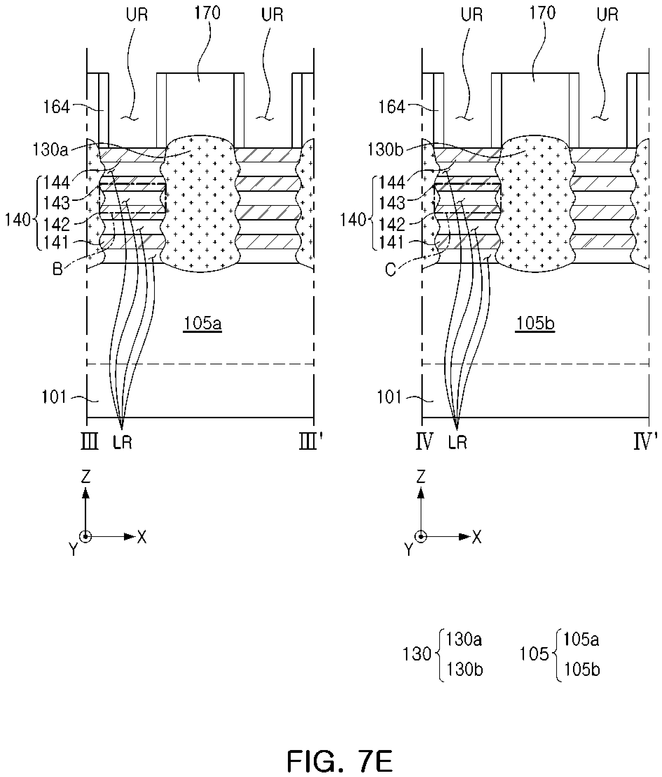

Referring to FIG. 7E, an interlayer insulating layer 170 may be partially formed, and sacrificial gate structures and sacrificial layers may be removed.

The interlayer insulating layer 170 may be formed by forming an insulating film covering the sacrificial gate structures 200 and the first and second source/drain regions 130a and 130b and performing a flattening process.

The sacrificial gate structures 200 and the sacrificial layers 120 may be removed selectively with respect to the gate spacer layers 164 and the channel structures 140. First, after the sacrificial gate structures 200 are removed to form upper gap regions UR, the sacrificial layers 120 exposed through the upper gap regions UR may be removed to form lower gap regions LR. For example, when the sacrificial layers 120 include silicon germanium (SiGe) and the channel structures 140 include silicon (Si), the sacrificial layers 120 may be selectively removed with respect to the channel structures 140 by performing a wet etching process.

Referring to FIG. 8A together with FIG. 7E, a spacer dielectric layer 151a may be formed below the plurality of channel layers 141, 142, 143 and 144 on the first active region 105a.

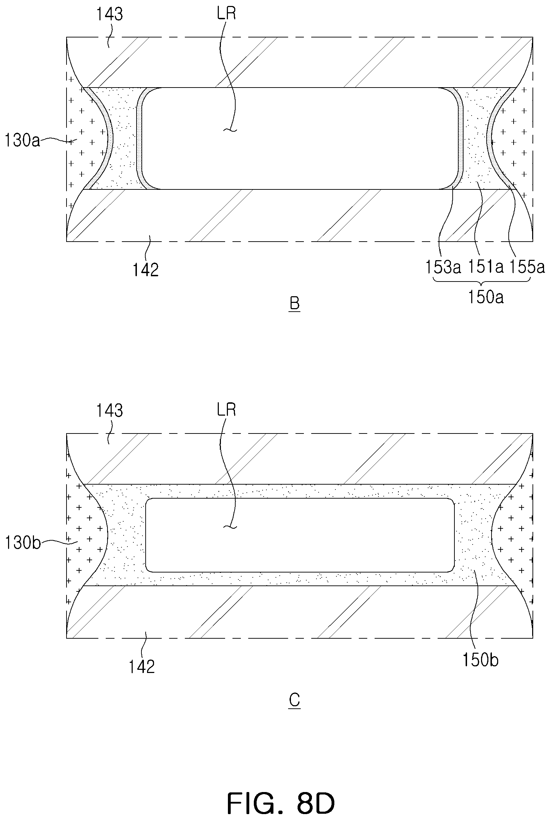

The spacer dielectric layer 151a may be formed along a surface of the first source/drain region 130a in the lower gap regions LR on the first active region 105a. However, according to some example embodiments, as in region 'C' of FIG. 8D, the spacer dielectric layer 151a may be formed along a surface of the source/drain region 130a, as well as along surfaces of the plurality of channel layers 141, 142, 143 and 144 and the first active region 105a. While a process is in progress on the first active region 105a, gap regions UR and LR on the second active region 105b may be blocked so that the process does not proceed on the second active region 105b,

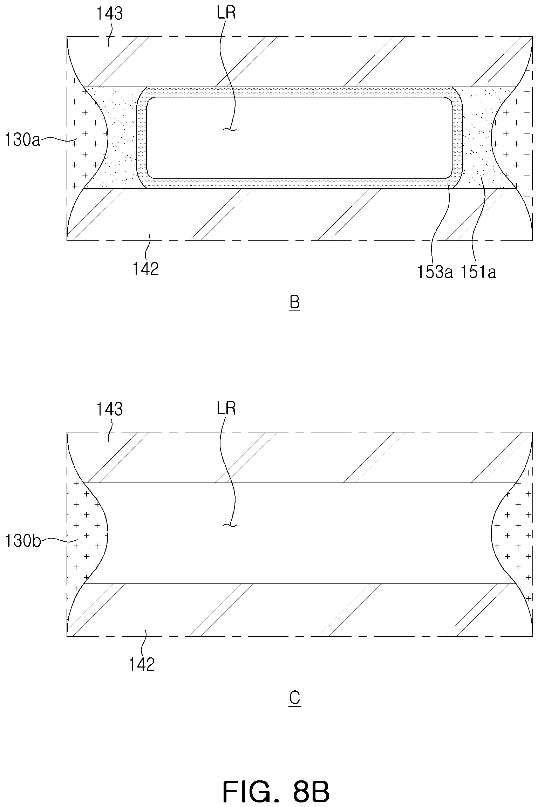

Referring to FIG. 8B together with FIG. 7E, a spacer insulating film 153a may be formed on the spacer dielectric layer 151a.

The spacer insulating layer 153a may be an oxide, a nitride, and/or an oxynitride formed on the spacer dielectric layer 151a and the plurality of channel layers 141, 142, 143 and 144 in the lower gap region LR. In some example embodiments, the spacer insulating film 153a may be a configuration in which silicon nitride (SiN) is formed on the spacer dielectric layer 151a and the plurality of channel layers 141, 142, 143 and 144 in the lower gap region LR, and may be oxidized to include silicon oxynitride (SiON). In some example embodiments, the spacer insulating film 153a may be a configuration provided with silicon oxide (SiO) formed by oxidizing an upper surface of a plurality of adjacent channel layers 141, 142, 143 and 144 or the first active region 105a. Depending on the material included in the spacer insulating layer 153a, the spacer insulating layer 153a may have etch selectivity different from that of the spacer dielectric layer 151a.

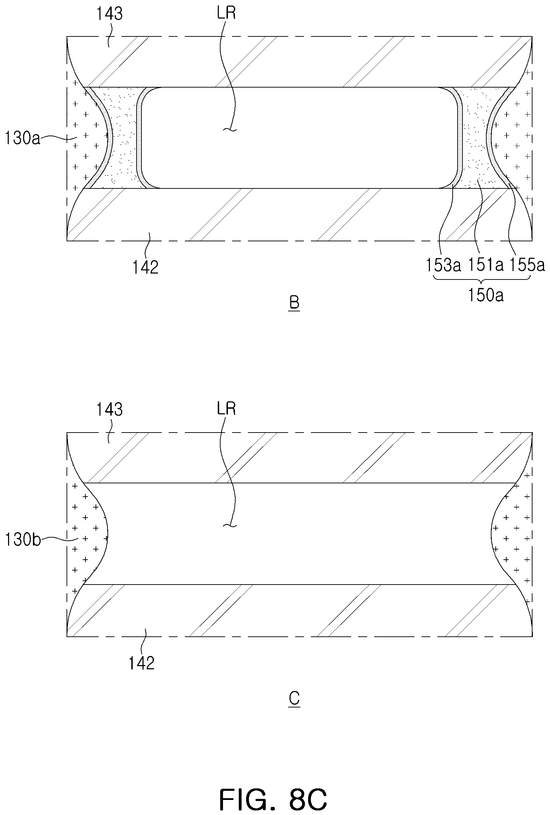

Referring to FIG. 8C together with FIG. 7E, a portion of the spacer dielectric layer 151a and the spacer insulating layer 153a may be removed through an etching process, and a first internal spacer 150a may be formed by forming a spacer pile-up film 155a.

A portion of the spacer insulating film 153a covering the plurality of channel layers 141, 142, 143, and 144 and the first active region 105a may be removed through an etching process. In this process, a thickness of the spacer insulating film 153a may become thinner. Accordingly, some of the surfaces of the plurality of channel layers 141, 142, 143, and 144 and some of the first active region 105a may be exposed as the lower gap region LR. In some example embodiments, due to a difference in etch selectivity between silicon oxide (SiO) and silicon nitride (SiN), the spacer insulating film 153a remains along a side surface of the spacer dielectric layer 151a, and a portion in contact with the plurality of adjacent channel layers 141, 142, 143 and 144 and the first active region 105a may be removed, so that a plurality of channel layers 141, 142, 143 and 144 and the first active region 105a may be exposed on the lower gap region LR. In some example embodiments, the spacer insulating film 153a may remain along a side surface of the spacer dielectric layer 151a due to a difference in thickness, and a portion in contact with the adjacent channel layers 141, 142, 143 and 144 and the first active region 105a may be removed.

The spacer pile-up film 155a may be formed by diffusion of a material included in the spacer insulating film 153a onto a surface of the first source/drain region 130a through the spacer dielectric layer 151a. The spacer pile-up film 155a may be formed along a side surface of the first source/drain region 130a. The spacer pile-up film 155a may include at least a portion of the material included in the spacer insulating film 153a, and may include a material different from the spacer dielectric layer 151a.

Depending on the differences in shape, thickness, degree of etching, and the like, the spacer dielectric layer 151a, the spacer insulating film 153a, and the spacer pile-up film 155a, several modified embodiments of FIGS. 3A to 3I may be manufactured. A side surface of the first internal spacers 150a in contact with the first source/drain region 130a may be determined according to a surface shape of a side surface of the first source/drain region 130a. A side surface of the first internal spacers 150a facing the gate structure 160 may be determined by the type of insulating material, an amount of insulating material, a forming method, an etching method, etching time, or the like.

Referring to FIGS. 8D to 8E together with FIG. 7E, second internal spacers 150b may be formed below the plurality of channel layers 141, 142, 143 and 144 on the second active region 105b.

The second internal spacers 150b may be formed for an etching process of exposing a plurality of channel layers 141, 142, 143 and 144 after a dielectric layer is formed along an upper surface of the second active region 105b, and surfaces of the plurality of channel layers 141, 142, 143 and 144 and the second source/drain region 130b in the lower gap regions LR on the second active region 105b. During a process of forming the second internal spacers 150b, gap regions UR and LR on the first active region 105a may be blocked to prevent the process from be advanced on the first active region 105a. A formation process of the second internal spacers 150b may be performed in the same or similar process, except for the process of forming the spacer insulating film 153a and the spacer pile-up film 155a in the first internal spacer 150a.

In this manner, first internal spacers 150a may be formed according to the process described with reference to FIGS. 8A to 8C, and in a separate process, a second internal spacers 150b may be formed according to the process of FIGS. 8D to 8E, thereby forming different types of internal spacers 150a and 150b optimized or improved for each source/drain region 130. In the process of FIGS. 8A to 8C, the second region R2 may be blocked to form the first internal spacers 150a only in the first region R1, and in the process of performing the processes of FIGS. 8D to 8E, the first region R1 may be blocked to form the second internal spacers 150b only in the second region R2. In the description referring to FIGS. 8A to 8E, it is described that the first internal spacers 150a are first formed, and then, the second internal spacers 150b are formed, and the process sequence is not limited thereto. For example, after first performing the process of region 'C' in FIGS. 8D to 8E to form the second internal spacers 150b, the first internal spacers 150a may be formed by performing the process in region 'B' of FIGS. 8A to 8C. When the first internal spacers 150a and the second internal spacers 150b are formed in the same shape as in the embodiment of FIG. 6B, the processes of FIGS. 8A to 8C may be performed simultaneously in region 'B' and region 'C'.

Referring to FIG. 9, gate structures 160 may be formed by forming gate dielectric layers 162 and a gate electrode 165.

The gate structures 160 may be formed to fill upper gap regions UR and lower gap regions LR. The gate dielectric layers 162 may be formed to conformally cover internal surfaces of the upper gap regions UR and the lower gap regions LR. After the gate electrode 165 is formed to completely fill the upper gap regions UR and the lower gap regions LR, the gate electrode 165, along with the gate dielectric layers 162 and the gate spacer layers 164, may be removed from an upper portion of the upper gap regions UR by a predetermined (or, alternatively, desired or selected) depth. As a result, the gate structures 160 respectively including the gate dielectric layers 162, the gate electrode 165, and the gate spacer layers 164 may be formed.

The gate dielectric layers 162, the gate electrode 165, and the gate spacer layers 164 may be formed to extend continuously in the Y-direction, and may be then removed in some regions by an etching process. Accordingly, the gate structures 160 separated from each other in the Y-direction may be formed. The gate structure 160 in the first region R1 may be referred to as a first gate structure 160a, and the gate structure 160 in the second region R2 may be referred to as a second gate structure 160b.

Then, referring to FIG. 5, an interlayer insulating layer 170 may be further formed on the gate structures 160, and contact structures 180 may be formed on a plurality of source/drain regions 130.

The contact structures 180 may be formed by partially removing the interlayer insulating layer 170 and then depositing a conductive material. A first contact structure 180a may be formed to be connected to the first source/drain region 130a, and a second contact structure 180b may be formed to be connected to the second source/drain region 130b. According to some example embodiments, after forming the contact structures 180, the contact structures 180 and the interlayer insulating layer 170 may be partially etched from upper surfaces thereof through a flattening process.

When the terms "about" or "substantially" are used in this specification in connection with a numerical value, it is intended that the associated numerical value includes a manufacturing or operational tolerance (e.g., ±10 %) around the stated numerical value. Moreover, when the words "generally" and "substantially" are used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10 %) around the stated numerical values or shapes.

Embodiments are set out in the following Clauses:
Clause 1. A semiconductor device, comprising:
   a substrate including an active region extending in a first direction;
   a gate structure extending in a second direction intersecting the active region on the substrate;
   on the active region, a plurality of channel layers spaced apart from each other in a third direction, perpendicular to an upper surface of the substrate, and surrounded by the gate structure;
   a source/drain region on at least one side of the gate structure and connected to the plurality of channel layers; and
   internal spacers between the plurality of channel layers and separating the gate structure and the source/drain regions,
   each of the internal spacers including
      a spacer insulating film in contact with the gate structure,
      a spacer pile-up film in contact with the source/drain region, and
      a spacer dielectric layer filling a space between the spacer insulating film and the spacer pile-up film, and
   the spacer dielectric layer including a material different from the spacer pile-up film and the spacer insulating film.
Clause 2. The semiconductor device of Clause 1, wherein
   the spacer pile-up film and the spacer insulating film include silicon nitride or silicon oxynitride, and
   the spacer dielectric layer includes silicon oxide.
Clause 3. The semiconductor device of Clause 1 or Clause 2, wherein in the first direction, each of the internal spacers has a concave shape toward the gate structure.
Clause 4. The semiconductor device of Clause 3, wherein a minimum thickness of each of the internal spacers in the first direction is 1 nm to 3 nm.
Clause 5. A semiconductor device, comprising:
   a substrate including a first region and a second region;
   a first active region extending in a first direction, in the first region on the substrate;
   a second active region extending in the first direction, in the second region on the substrate;
   a first gate structure extending on the first active region, in a second direction, intersecting the first direction;
   a second gate structure extending in the second direction on the second active region;
   on the first and second active regions, a plurality of channel layers spaced apart from each other in a third direction, perpendicular to an upper surface of the substrate, and surrounded by the gate structure;
   on both sides of the first gate structure, a first source/drain region in a first region in which the first active region is recessed, the first source/drain region connected to the plurality of channel layers on the first active region and having a first conductivity-type;
   on both sides of the second gate structure, a second source/drain region in a second region in which the second active region is recessed, the second source/drain region connected to the plurality of channel layers on the second active region and having a second conductivity-type, different from the first conductivity-type;
   first internal spacers separating the first gate structure and the first source/drain region, below each of the plurality of channel layers on the first active region; and
   second internal spacers separating the second gate structure and the second source/drain region, below each of the plurality of channel layers on the second active region,
   a central thickness of each of the first and second internal spacers in the first direction is smaller than a thickness of an upper end of each of the first and second internal spacers.
Clause 6. The semiconductor device of Clause 5, wherein
   the first conductivity-type is an N-type, and
   the second conductivity-type is a P-type.

The present disclosure is not limited to the above-described embodiments and the accompanying drawings but is defined by the appended claims. Therefore, those of ordinary skill in the art may make various replacements, modifications, or changes without departing from the scope of the present disclosure defined by the appended claims, and these replacements, modifications, or changes should be construed as being included in the scope of the present disclosure.

## Claims

1. A semiconductor device, comprising:
a substrate including a plurality of active regions extending in a first direction and including first and second active regions spaced apart from each other in a second direction, intersecting the first direction;
a plurality of gate structures extending on the substrate in the second direction, and including a first gate structure intersecting the first active region and a second gate structure intersecting the second active region;
on each of the plurality of active regions, a plurality of channel layers spaced apart from each other in a third direction, perpendicular to an upper surface of the substrate, and surrounded by the gate structure;
on one side of each of the plurality of gate structures, a plurality of source/drain regions including a first source/drain region in a first region in which the first active region is recessed, the first source/drain region connected to the plurality of channel layers on the first active region and having a first conductivity-type, and a second source/drain region in a second region in which the second active region is recessed, the second source/drain region connected to the plurality of channel layers on the second active region and having a second conductivity-type, different from the first conductivity-type;
first internal spacers between the first gate structure and the first source/drain region, below each of the plurality of channel layers on the first active region; and
second internal spacers between the second gate structure and the second source/drain region, below each of the plurality of channel layers on the second active region,
each of the first internal spacers including a spacer dielectric layer and a spacer insulating film between the spacer dielectric layer and the gate structure, and
a central thickness of each of the first internal spacers in the first direction is greater than a central thickness of each of the second internal spacers in the first direction.

2. The semiconductor device of claim 1, wherein
at least some of the first internal spacers further includes a spacer pile-up film in contact with the first source/drain region, and
the spacer pile-up film includes a material different from the spacer dielectric layer.

3. The semiconductor device of claim 2, wherein the spacer pile-up film extends along a surface of the first source/drain region between the plurality of channel layers.

4. The semiconductor device of claim 2 or claim 3, wherein the spacer dielectric layer is spaced apart from the first source/drain region by the spacer pile-up film.

5. The semiconductor device of any of claims 2-4, wherein
the spacer dielectric layer includes silicon oxide, and
the spacer pile-up film includes silicon nitride.

6. The semiconductor device of claim 5, wherein the spacer insulating film includes silicon nitride or silicon oxynitride.

7. The semiconductor device of any preceding claim, wherein
the first conductivity-type is an N-type, and
the second conductivity-type is a P-type.

8. The semiconductor device of any preceding claim, wherein in the first direction, at least some of the first and second internal spacers have a concave shape toward the gate structure.

9. The semiconductor device of any preceding claim, wherein a central thickness of each of the second internal spacers in the first direction is smaller than a top thickness of each of the second internal spacers in the first direction.

10. The semiconductor device of any preceding claim, wherein in the first direction, a top thickness of each of the first internal spacers is greater than a top thickness of each of the second internal spacers.

11. The semiconductor device of any preceding claim, wherein in at least a portion of each of the first internal spacers, the spacer dielectric layer is spaced apart from the gate structure by the spacer insulating film.

12. The semiconductor device of any preceding claim, wherein
the first internal spacers include at least one of silicon oxynitride and silicon nitride, and
the second internal spacers include silicon oxide.

13. The semiconductor device of any preceding claim, wherein
a central thickness of each of the first internal spacers is 1 nm to 3 nm, and
a central thickness of each of the second internal spacers is 0.5 nm to 2 nm.

14. The semiconductor device of any preceding claim, wherein in at least some of the first internal spacers, the spacer insulating film surrounds the gate structure between the plurality of channel layers.

15. The semiconductor device of any preceding claim, wherein the spacer insulating film includes a material different from the spacer dielectric layer.
